(19) Europäisches Patentamt
European Patent Office
Office européen des brevets

(11) **EP 3 155 723 B1**

(12) **EUROPÄISCHE PATENTSCHRIFT**

(45) Veröffentlichungstag und Bekanntmachung des Hinweises auf die Patenterteilung:
**11.11.2020  Patentblatt 2020/46**

(21) Anmeldenummer: **15713668.0**

(22) Anmeldetag: **23.03.2015**

(51) Int Cl.:
*H03K 17/96* (2006.01)    *G06F 3/044* (2006.01)

(86) Internationale Anmeldenummer:
**PCT/EP2015/056030**

(87) Internationale Veröffentlichungsnummer:
**WO 2015/188955 (17.12.2015 Gazette 2015/50)**

(54) **FOLIE MIT INTEGRIERTER SENSORIK**

SHEET WITH INTEGRATED SENSOR SYSTEM

FEUILLE POURVUE DE CAPTEURS INTÉGRÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.06.2014  DE 102014211239**

(43) Veröffentlichungstag der Anmeldung:
**19.04.2017  Patentblatt 2017/16**

(73) Patentinhaber: **Benecke-Kaliko AG**
**30419 Hannover (DE)**

(72) Erfinder:
• **GERKEN, Andreas**
  **30161 Hannover (DE)**

• **BÜHRING, Jürgen**
  **30900 Wedemark (DE)**
• **PRÖMPERS, Günter**
  **30827 Garbsen (DE)**

(74) Vertreter: **Kilsch, Armin Ralph**
**Continental Aktiengesellschaft**
**Patente und Lizenzen**
**Postfach 169**
**30001 Hannover (DE)**

(56) Entgegenhaltungen:
**EP-A2- 1 626 331       WO-A1-2013/013905**
**DE-A1-102006 008 385   DE-A1-102011 006 402**
**US-A- 4 562 315**

**Beschreibung**

Die Erfindung betrifft eine flexible Kunststofffolie aus polymerem Material als Verkleidung von Armaturenbrettern, Sitzen, Wänden oder Türen in Fahrzeugen, wobei die Kunststofffolie mit einer Narbung oder Prägung versehen ist, wobei das Flächenelement funktionale Flächenbereiche aufweist, die als Schalt-, Sensor- oder Bedienelement ausgebildete sind, wobei das Flächenelement insgesamt ein oder mehrschichtig, mindestens jedoch im Bereich der funktionalen Flächenbereiche mehrschichtig ausgebildet ist.

Solche Flächenmaterialien sind als Beschichtungen bei einer Vielzahl von Gegenständen bekannt. So weisen z. B. Armaturenbretter, Sitzbezüge und Türverkleidungen für Kraftfahrzeuge Leder- oder Textilbezüge auf, oder auch kunstlederne Innenverkleidungen / Kunststoffinnenverkleidungen mit dreidimensional geprägter Oberflächen bzw. Narbung. Auch Oberflächen von Möbeln oder anderen Gebrauchsgegenständen, PC- oder Büromaschinengehäusen und Telefonen, etc. sind oft mit einem flexiblen Flächenmaterial bzw. mit einer genarbten/geprägten Kunststofffolie versehen, um nur einige Beispiele zu nennen.

Folien für die Innenverkleidung von Kraftfahrzeugen, für Möbel, Taschen oder ähnliches, landläufig auch als Kunstleder bezeichnet, sind weithin bekannt und besitzen oft einen mehrschichtigen Aufbau, sind oft unterschäumt und zeigen auf ihrer Oberseite dreidimensional strukturierte Oberflächen in verschiedensten Formen und Ausführungen. Der mehrschichtige Aufbau besteht in aller Regel aus einer oberen Deck- oder Dekorschicht, die mit der geprägten oder eingeformten Oberfläche versehen ist, und aus einer oder mehreren Unterschichten. Die Deckschicht ist in der Regel mit einer Lackschicht versehen und kann auch eingefärbt werden. Durch entsprechendes Einstellen der Schichten, auch durch angepasste Weichheit oder durch die bereits genannten geschäumten Schichten entsteht eine ansprechende Haptik, d.h. eine angenehm "weiche" Griffigkeit der Kunststofffolie sowie auch ein bestimmter Glanz, d.h. bestimmte Reflexionseigenschaften.

Da z. B. bei den Dekorfolien und auch im Bereich des Automobilinterieurs insgesamt ein starker Trend zur Verbesserung der Qualitätsanmutung und der "Funktionalisierung" zu beobachten ist, sollen Oberflächen solcher Gegenstände oft besondere Eigenschaften oder Funktionen aufweisen.

Im Kfz-Innenraum müssen und können eine Vielzahl von Funktionen durch die Fahrzeuginsassen geregelt und gesteuert werden, z.B. Klimaanlage, Heizfunktionen, Betätigung der Fensterheber, Einstellung von Spiegeln und Lampen, Musikanlageneinstellungen, Navigationsgeräteinsellungen, Bedienung von Kommunikationsgeräten etc.

Zur Bedienung dieser Funktionen sind in der Regel eine Vielzahl von separaten und in die Oberflächen von z.B. Armaturenbrett und Türverkleidung eingelassene Reglern, Schaltern und Einstelltaster etc. als "Human to Machine Interface (HMI) " notwendig, die bei der Innenraumgestaltung von den Designern berücksichtigt werden müssen und häufig die Designlinie im Innenraum stören. Zudem wirkt die Vielzahl von sichtbaren Einstellmöglichkeiten in modernen Fahrzeugen häufig unübersichtlich und erschwert dadurch eine intuitive Bedienung.

Es wurde bereits darüber nachgedacht, zur Bereitstellung von Bedienfunktionen in die Bedienoberfläche von Gegenständen eine Sensorik zu integrieren. Bei flexiblen Folien mit genarbten oder geprägten Oberflächen, wie z.B. bei Kunstlederfolien für den Automobilinnenraum, die nicht nur extremen Dehnungen bei der Herstellung und beim Aufbringen auf die festen Trägen unterworfen sind, sondern auch höchsten Temperaturschwankungen im Betrieb, ist die Integration von Sensorik jedoch schwierig und deshalb bisher nicht durchgesetzt.

Auf der anderen Seite sind Berührungssensoren als HMI in vielen Bereichen schon etabliert, z.B. als touch-screen-Einrichtungen bei Smartphones. Solche Bedienungselemente oder -funktionen ermöglichen eine intuitive Bedienung bei gleichzeitiger Vermeidung mechanischer Knöpfe, Schalter, Drehregler oder Einstellräder.

Bekannt bei solchen Berührungssensoren sind resistive und kapazitive Systeme. Resistive Systeme beruhen in der Regel auf zwei Lagen mit elektrisch leitendem oder halbleitendem Material (häufig ITO = Indium-Zinnoxid), wobei beide Lagen durch eine dünne Luftschicht oder Mikropunkte beabstandet sind. Durch Druck auf eine bestimmte Stelle werden beide Lagen kontaktiert und ein elektrisches Messsignal, welches durch die untere Lage gesendet wird, wird dadurch verändert. Dadurch lässt sich der Berührungspunkt lokalisieren. Solche Systeme sind Standard für starre Anwendungen wie Displays von Telefonen und Bediengeräten. Flexible und gleichzeitig dehnfähige Anwendungen lassen sich jedoch so nicht realisieren.

Kapazitive Berührungssensoren beruhen auf einem kapazitiven Kupplungseffekt. Durch eine geeignete Beschichtung eines Substrats können auch eine Vielzahl voneinander unabhängige Berührungssensoren realisiert werden, die auch die gleichzeitige Detektion einer Vielzahl von Berührungspunkten erlauben. Typischerweise ist die zu berührende Fläche mit einem Sensor-Array, d.h. mit einer Anordnung einer Vielzahl von horizontalen und vertikalen Sensoren versehen, die als Sender oder Empfänger elektrischer Signale dienen. Ein solches System offenbart die US 2006097991 A1, wobei dort ein so genanntes "Touch-Panel" gezeigt ist, welches eine transparente kapazitive Sensoranordnung aufweist, die unterschiedliche Positionen von Berührungen auf der Bedienfläche oder Funktionsfläche erkennen und in Signale umformen kann.

Andere Sensoreinrichtungen sind ebenfalls bekannt, so z.B. Sensoren, die auf der Auswertung optischer Signale und Reflexionen im visuellen oder infrarotem Bereich basieren. Letztere sind jedoch nur für transparente oder transluzente Berührungsflächen geeignet. So genannte "taktile Sensoren" werden beispielsweise in "künstlicher Haut" für Roboter oder minimalinvasive Chirurgie, tragbaren Computer etc. eingesetzt und beinhalten in der Regel Piezoelemente oder kapazitive Sensorelemente. Piezoelemente sind aufgrund ihrer pysikalischen Eigenschaften nund ihrer Funktionsweise allerdings für dehnfähige und flexible Anwendungen nicht geeignet. Piezoelektrische Polymerfilme, druckempfindliches leitfähiges Gummi, Polymere mit Carbonfasern oder leitfähige Polymere sind im Labormaßstab bekannt, aber wegen ihrer nur geringen Dicke in der Anwendung als Membran nur wenig dehnfähig und können deswegen auch nur begrenzt eine Kraft aufnehmen und detektieren.

Neuerdings wurde auch von Berührungssensoren auf Basis von "quantum tunnel composites" berichtet, zum Beispiel zur Bedienung von mp3-Playern oder Mobiltelefonen, die quasi unsichtbar in der Kleidung integriert sind. Solche Systeme enthalten leitfähige Partikel in einer elastomeren Matrix, die sich aber nur bei Druck annähern, sodass dann durch den elastomeren Binder Elektronen durchtunneln können, wodurch das System an dieser Stelle elektrisch leitfähig wird. Ohne Druckbelastung sind solche Systeme Isolatoren. Der Nachteil solcher Systeme ist die Notwendigkeit einer mechanischen Druckbelastung zur Funktion und die Dehnungsempfindlichkeit, da bei undefinierten Dehnungen auch die Durchtunnelwahrscheinlichkeit der Elektronen beeinflusst wird.

Bekannt sind auch Sensoren auf Basis von leitfähigen Textilien. Solche Sensoren sind flexibel und dehnfähig. Allerdings müssen die leitfähigen textilen Fäden entweder in üblichen textilen Verarbeitungsverfahren (Stricken, Weben etc.) verarbeitet werden, so dass nur flächige einzelne/separate elektrische Gebilde erzeugt werden können ohne eine benutzerdefinierte Geometrie oder die leitfähigen Fäden müssen benutzerdefiniert auf einen textilen Untergrund aufgestickt werden, so dass ein aufwändiger Arbeitsgang notwendig ist und die textile Ebenheit deutlich negativ beeinflusst ist.

Die Zeitschrift Kunststoffe 11/2012, S. 31 ff zeigt Bauteile mit integrierter Sensorik für den Automobilinnenraum, welche auf Basis einer kaum flexiblen und nicht dehnbaren Polycarbonatfolie gefertigt sind. Leitfähige Bahnen und Sensorflächen müssen hier jedoch aufwändig im Laser-Direkt-Verfahren erzeugt werden, indem ein Laser leitfähige Additive in der Kunststofffolie freilegt. Dieses Vorgehen erfordert eine sehr aufwendige Herstellung solcher Folien in einem kostspieligen mehrstufigen Verfahren. Eine Herstellung "von der Rolle" ist nicht möglich.

Die US 7,145,432 B2 offenbart ein druckempfindliches flexibles Schaltelement in Folienform als Bedienungselement (user interface), welches textilartige Elektroden aufweist, die über und unter einem textilem Element angeordnet sind, welches seinen elektrischen Widerstand druckabhängig ändert. Die Elektroden detektieren die Widerstandsänderung und erzeugen somit ein in vielen Anwendungen verwertbares Signal. Wird ein solches Bedienelement jedoch unter starker Dehnung auf einen Träger gespannt und dort fixiert, ist in den gedehnten Bereichen die Schaltfunktion verändert oder behindert.

Die DE 10 2006 008 385 A1 offenbart eine ein- oder mehrschichtige Kunststoffhaut als Oberflächenbelag von beschichteten Gegenständen, wobei die Kunststoffhaut Bereiche aufweist, in denen Schalt-, Sensor- oder Signalübertragungsfunktionen vorhanden sind. Hierbei können diese Elemente auch innerhalb der Kunststoffhaut angeordnet sein, vorzugsweise in den äußeren Oberflächenbereichen der Kunststoffhaut. Eine detaillierte Ausbildung der Funktionsweise dieser Elemente ist jedoch nicht offenbart.

Die US 4 562 315 offenbart einen kapazitiven Folienschalter, der insbesondere dadurch gekennzeichnet ist, dass eine leitfähige Klebeschicht/ein leitfähiger Kleber innerhalb der einzelnen schalterbildenden Folien vorgesehen ist. Der Folienschalter weist eine Reihe von übereinander angeordneten Schichten und Kondensatorplatten oder -folien auf, die so ausgebildet sind das mehrere Kapazitäten in Reihe geschaltet sind und entsprechend deutliche Signale ausbilden. Solche Folienschalter werden beispielsweise verwendet als Bedienelemente für Computer-Keyboards und als Tastaturen an Bedienfeldern von Geräten, sind aber als Innenverkleidung für Fahrzeuge nicht geeignet.

Bei allen Methoden gelang es bisher nicht zufriedenstellend, dass ein dekoratives, Flächenmaterial mit einer integrierten Sensorik so flexibel und dehnfähig ausgebildet wurde, dass es auf ebenso einfache Art auf Trägerbauteile aufgebracht werden konnte wie herkömmliche Folien ohne Sensorik.

Für die Erfindung bestand also die Aufgabe, eine Folie mit integrierten flächigen Schalt-, Sensor- oder Bedienelement so flexibel und dehnfähig bereitzustellen, die als Oberflächen- bzw. Dekorflächenmaterial eingesetzt werden kann, also etwa als dekorative Folie mit integrierten Sensorflächen im Kfz-Innenraum, bei der eine beliebige Anzahl von flächigen Schalt-, Sensor- oder Bedienelementen mit unterschiedlichen Geometrien in die Folie eingebunden werden kann, ohne das Erscheinungsbild der dekorativen Oberfläche negativ zu beeinflussen, wobei die Schalt-, Sensor- oder Bedienfunktionen bereits durch eine leichte Berührung der Dekorfolie auf den Schalt-, Sensor- oder Bedienflächen ausgelöst werden können, .

Desweiteren sollen die erfindungsgemäßen Flächenmaterialien kostengünstig herstellbar und in üblichen Verarbeitungsverfahren für automobile Dekorfolien wie Vernähen, Verpolstern, Tiefziehen oder Kaschieren verarbeitbar sein.

Gelöst wird diese Aufgabe durch die Merkmale des Hauptanspruchs. Weitere vorteilhafte Ausbildungen sind in den Unteransprüchen offenbart.

Dabei ist in den funktionale Flächenbereichen mindestens eine Schicht aus leitfähigem polymerem Material angeordnet, die als Kondensatorplatte oder Kondensatorfolie ausgebildet ist, wobei die Schicht aus leitfähigem Material von der sichtbaren Oberfläche der Folie rückseitig beabstandet und über Kontakte/Kontakt-Elektroden mit einer elektronischen Steuer- und Regeleinrichtung verbunden ist, welche Veränderungen elektrischer Eigenschaften der Folie in den funktionalen Flächenbereichen detektiert und in Stell- Schalt- oder Steuersignale umformt.

Innerhalb der funktionalen Flächenbereiche ist also eine Schicht des polymeren Materials leitfähig ausgebildet, so dass die physikalischen Eigenschaften der Folie, wie z.B. Dehnungsfähigkeit oder Flexibilität durchgehend einheitlich sind. Dadurch kann der mehrschichtige Folienverbund wie "eine" Folie verarbeitet und auf einen Träger aufgebracht werden. Die Schalt-, Sensor- oder Bedienelement sind so bereits integriert und anschlussfertig ausgebildete, wonach separate Schalter und Einbauten weitgehend entfallen. Typischerweise kann durch Berührung der funktionalen Flächenbereiche einer solchen Folie ein Fensterheber bedient oder eine Eingabe in ein Klima- oder Navigationsgerät vorgenommen werden. Die Bedienung von Funktionen erfolgt so auf eine einfachere und intuitivere Art.

Durch die Lösung der Aufgabe wird also eine flexibles und ggf. dehnbare dekoratives Flächenelement oder ein Kunstleder bereitgestellt, durch dessen Verwendung vermieden werden kann, z.B. im Automobilinnenraum Schalter oder Regler einzusetzen, die den dekorativen Gesamteindruck der Folie oder des Innenraums stören.

Zudem kann vor Verarbeitung der Folie die Lage der funktionalen Flächenbereiche frei definiert werden. Die Lage der funktionalen Flächenbereiche kann unsichtbar sein oder bewusst sichtbar gemacht werden, indem auf der dekorativen Oberfläche bewusst Symbole auf der den Sensorflächen gegenüberlegenden Seite gedruckt werden. Die Lage der funktionalen Flächenbereiche kann auch durch eine in der Folie oder hinter der Folie liegende Beleuchtung oder durch eine Projektion von einer außenliegen Lichtquelle sichtbar gemacht werden.

Eine vorteilhafte Weiterbildung besteht darin, dass die Schichten aus polymerem leitfähigem Material gleiche Dehnfähigkeit aufweisen wie die Folie aus polymerem Material und auf der Folienrückseite oder innerhalb der Foliendicke bzw. des Folienmaterials angeordnet sind. Damit können die erfindungsgemäßen Folien problemlos auf Trägerkonstruktionen aufgezogen/aufgebracht werden, ohne das nennenswerter Verzug zwischen den funktionalen Flächenbereichen und den übrigen Flächen auftritt. Dies gilt natürlich für die in den entsprechenden Anwendungen üblicherweise vorhandenen Dehnungen bis zu 300 % der ursprünglichen Länge, insbesondere jedoch bis 100 % und vorzugweise bei Dehnungen bis 50 %.

Eine weitere vorteilhafte Ausbildung besteht darin, dass in den funktionalen Flächenbereichen unterhalb der sichtbaren Oberfläche eine als Kondensatorplatte oder Kondensatorfolie ausgebildete Schicht aus leitfähigem Material angeordnet ist. Damit lässt sich eine besonders empfindliche und feinfühlige Sensorik aufbauen. Gleiches gilt für eine weitere vorteilhafte Ausbildung, die darin besteht, dass die als Kondensatorplatten oder Kondensatorfolien ausgebildeten Schichten aus leitfähigem Material als Teil eines Schwingkreises (LC-Kreis) ausgebildet sind.

Generell ist ein Kondensator in der Weise aufgebaut, dass sich zwei elektrisch leitfähige Platten, jeweils mit der Fläche A, in planparalleler Anordnung befinden und sich durch ein dielektrisches Material mit einer Dielektrizitätszahl $\varepsilon r$ getrennt in einem Abstand d befinden. Planparallel heißt dann hier folien-parallel, d.h. parallel innerhalb der Foliendicke bzw. Folienausbildung

Die Kondensatorkapazität ergibt sich somit aus der Formel:

$$C = \varepsilon r * \varepsilon 0 * A/d$$

mit

- A = Elektrodenfläche
- d = Plattenabstand
- $\varepsilon 0$ = elektrische Feldkonstante
- $\varepsilon r$ = materialspezifische Dielektrizitätszahl

Genutzt wird das Prinzip, dass der menschliche Körper eine elektrische Kapazität besitzt, was sich in der Speicherfähigkeit elektrischer Energie im Vergleich zur direkten Umgebung äußert. Diese Eigenschaft wird schon in track pads bei Laptop-Computern, touch screens in Smart Phones und Annäherungsdetektoren ausgenutzt.

Dabei bildet eine elektrisch leitfähige Sensorelektrode eine Platte eines Kondensators, während die zweite korrespondierende Kondensatorplatte durch die direkte Sensorumgebung (als parasitäre Kapazität) und einem zusätzlichen leitfähigen Objekt (beispielsweise einem sich nähernden Finger) als Berührungskapazität gebildet wird. Eine Detektion einer Annäherung eines Körperteils an eine Sensorelektrode kann jetzt dadurch erfolgen, indem die Sensorelektrode an eine Messelektronik angeschlossen und die Kapazität gemessen wird. Wenn sich der Sensorfläche ein elektrisch leitfähiger Körper nähert, steigt die gemessene Kapazität an und die angeschlossene Messelektronik gibt ein Triggersignal aus, mit dem beispielsweis eine externe Funktion ausgelöst werden kann. Für die Empfindlichkeit eines derart aufgebauten Sensors ist wie aus der Formel oben ersichtlich die Größe der Sensorflächen, das gewählte Material, welches zur Isolierung gewählt wird und der Abstand der beiden "Platten" zueinander entscheidend.

Ein weiteres Beispiel für solche kapazitive Sensoren sind Luftfeuchtigkeitsmesser, die ihre Kapazität entsprechend der Luftfeuchtigkeit ändern. Das Auslesen der Kapazität kann prinzipiell über das Ausmessen von Ladekurven geschehen. Dies ist jedoch bei kleinen Kapazitäten nicht praktisch durchführbar, weshalb man in diesem Falle meist einen Schwingkreis baut, dessen Frequenz man dann misst und so dann zusammen mit der bekannten Induktivität der Spule die Kapazität des Kondensators ausrechnen kann. In der Regel geschieht aber die Messung und Auswertung der Frequenzänderung in einem Schwingkreis, der durch Anlegen einer Messfrequenz an die elektrisch leitfähige Beschichtung entsteht.

Die erfindungsgemäße Flächenelement kann auch zur reinen Detektion, ob eine Berührung mit der Oberfläche überhaupt stattfindet, verwendet werden, beispielsweise, um Sitzbelegungen im Kfz zu prüfen. Die Methode beruht darauf, dass dasdielektrische Flächenelement mit der elektrisch leitfähigen Beschichtung/Bedruckung z. B. auf der Rückseite mit der Berührfläche einen Kondensator ausbildet und die elektrisch leitfähige Schicht mit einem Messsignal, beispielsweise mit einer bestimmten Messspannung und/oder Messfrequenz und mit der Fahrzeugkarosserie als Erdung verbunden ist. Erfolgt eine Berührung, entsteht eine kapazitive Kopplung zwischen der Berührfläche desFlächenelements und der Fahrzeugkarosserie und das Messsignal wird charakteristisch verändert.

Eine weitere vorteilhafte Ausbildung besteht darin, dass in den funktionalen Flächenbereichen unterhalb der sichtbaren Oberfläche mehrere als Kondensatorplatten oder Kondensatorfolien ausgebildete Schichten aus leitfähigem Material angeordnet sind, insbesondere durch Folienmaterial voneinander isolierte Kondensatorplatten oder Kondensatorfolien. Damit kann das Mess-Signal verstärkt werden, wenn bereits eine Mess-Ladung an die Platten angelegt wird.

Eine weitere vorteilhafte Ausbildung besteht darin, dass die Schichten aus leitfähigem Material als Antennen ausgebildet sind, die im Bereich der funktionalen Flächenbereiche ein elektrisches Feld erzeugen.

Dabei befindet sich auf der der Rückseite oder zumindestens nicht auf der Oberfläche des zu berührenden Flächenelements, das als Dielektrikum wirkt, eine elektrisch leitfähige Beschichtung/Bedruckung die zu mindestens einer weiteren elektrisch leitfähigen Beschichtung beabstandet ist. Dabei wirkt die eine elektrisch leitfähige Beschichtung nach Anlegen eines Messsignals an dieser als Sender, der ein elektrisches Feld erzeugt und die weitere elektrische Beschichtung als Empfänger des elektrischen Feldes. Die Feldstärke am Empfänger kann elektronisch ausgewertet werden und wird durch die Annäherung eines Körperteils an die Oberfläche der Folie und somit durch die Annäherung an das elektrische Feld, das zwischen Sender und Empfänger durch Anlegen des Messsignals (Messspannung) entsteht, verändert. Eine Berührung kann somit detektiert werden.Die Beabstandung zwischen den elektrisch leitfähigen Flächen kann in einer Fläche erfolgen, indem die elektrisch leitfähige Schicht unterbrochen ist oder auch indem die erste elektrisch leitfähige Schicht mit einer weiteren elektrisch isolierenden Schicht versehen wird, worauf wieder eine elektrisch leitfähige Schicht aufgebracht wird.

Eine weitere vorteilhafte Ausbildung besteht darin, dass das Flächenelement als mehrschichtige Verbundfolie ausgebildet ist, bei der die Schichten aus leitfähigem Material im Bereich der funktionalen Flächenbereiche aus elektrisch leitfähiger Polymermasse bestehen, welche als leitfähige Paste auf die Folienrückseite oder auf Folienschichten innerhalb des Folienverbundes aufgetragen wird, vorzugsweise im Siebdruckverfahren. Vorteilhafterweise erfolgt die Beschichtung oder der Auftrag mit einer Menge zwischen 10 g/m² und 2000 g/m².

Die Herstellung der Dekorfolien erfolgt zum Beispiel damit wie folgt: Ein Kunstleder, bestehend aus einem textilen Träger und einer polymeren ein- oder mehrschichtigen polymeren Beschichtung, beispielsweise auf Basis von PVC und/oder Polyolefinen und/oder Polyurethan, wird auf der freien, rückseitig sichtbaren Textilseite mit der unten beschriebenen Polymermasse bedruckt.

Als Textil wird ein Polyestergewebe mit 47 g/m2 Flächengewicht verwendet. Die Beschichtungsmasse wird mittels einer Siebdruckwalze mit einem gewünschten Druckmuster auf die textile Rückseite gleichmäßig an den Positionen aufgetragen, so dass die getrocknete Masse eine elektrisch leitfähige Sensorfläche bildet.

Die aufgetragene erfindungsgemäße Beschichtungsmasse wird mit einem Gewicht von 800 g/m² aufgetragen. Nachfolgend wird der beschichtete flexible Träger in einem abgestuften Heizprozess ausgehärtet, indem zuerst 2 min bei 80°C, dann 2 min bei 100°C und nachfolgend 2 min bei 120°C appliziert werden. Die Masse der aufgetragenen Beschichtung beträgt nach dem Trocknungsprozess ca. 540 g/m².

Das verwendete Sieb, bzw. dessen Bedruckung gibt die Position, Geometrie und Stärke der Sensorflächen an. Die gewünschten Auftragsgewichte der elektrisch leitfähigen Polymermasse lassen sich über die Beschichtungsstärke der Beschichtung des Siebes, die Siebgröße, über den Rakeldruck und die Viskosität der elektrisch leitfähigen Paste einstellen.

Eine weitere vorteilhafte Ausbildung besteht darin, dass die leitfähige Polymermasse leitfähige feinteilige metallische und/oder metallisch beschichtete Füllstoffpartikel enthält, vorzugsweise in dendritischer Form oder in Kern-Schale-Morphologie.

In diesem Beispiel wird eine elektrisch leitfähige Paste verwendet, die auf folgende Art hergestellt wird: 345 g einer wässrigen aliphatischen Polyester-Polyurethandispersion (mit 50 % Festkörpergehalt) werden mit 6 g eines assoziativ wirksamen Verdickers, 258,75 g von feinteiligen Füllstoffpartikel mit dendritischer Form auf Basis von oberflächlich mit Silber beschichtetem Kupfer und 86,25 g von feinteiligen Partikeln mit sphärischer oder länglicher Gestalt und 5 g eines Isocyanatvernetzers auf Basis von trimeren Hexamethylendiisocyanat mit 21,8 % Gehalt an freien Isocyanatgruppen unter Rühren mit einem Dissolver bei 800 Umdrehungen/Minute homogen vermischt. Optional zur Einstellung der Viskosität werden hier 215 g destilliertes Wasser zusätzlich zugegeben.

Die Kontaktierung der elektrisch leitfähigen Sensorflächen erfolgt auf folgende Art: Die Kontaktbänder, die mit einem Schmelzkleber versehen sind, werden mit einem Bügeleisen oder einer beheizten Walze oder Roller vorfixiert und nachfolgend mit der gleichen elektrisch leitfähigen Paste über die ganze Sensorfläche oder nur an einer Position der Sensorfläche mittels einer Pipette imprägniert, so dass idealerweise eine innige elektrisch leitfähige Verbindung zwischen den Leitfähigkeitsbändern und der Sensorfläche entsteht.
Die Leitfähigkeitspaste wird danach thermisch in einem Ofen 4 min bei 80 °C und nachfolgend 2 min bei 120°C ausgehärtet.

Die Kontaktierung kann auch so erfolgen, dass elektrisch leitfähige Pfade mit der beschriebenen leitfähigen Paste oder einer anderen elektrisch leitfähigen Paste gedruckt werden und die Kontaktierung an einer anderen Position des gedruckten leitfähigen Pfades erfolgt.

Eine weitere vorteilhafte Ausbildung besteht darin, dass die funktionalen Flächenbereiche von der Folienrückseite oder von der Folienseite her beleuchtbar sind. Somit können auch im Dunkeln funktionale Flächenbereiche einfach gekennzeichnet oder durch Leuchten z.B. eine Rückmeldung oder eine Eingabeaufforderung eingeschaltet werden.

Zum Beispiel kann nach Auslösung einer Funktion durch Annäherung an eine Sensorfläche eine sensorische Rückkopplung erfolgt etwa durch das Aufleuchten eines Lichtes an der entsprechenden Stelle, optische Projektion eines Symbols auf die Fläche, durch eine schwache Vibration an der entsprechenden Stelle (etwa durch unterhalb der Folie oder durch in die Folie integrierte Aktoren), akustische Signale oder durch eine spezielle Oberflächenstruktur (z. B. andere Narbung als die Umgebung oder Vertiefung).

Auch kann dem Benutzer schon bei Annäherung an die Sensorfläche durch Maßnahmen wie das Aufleuchten eines Lichtes an der entsprechenden Stelle, durch eine schwache Vibration an der entsprechenden Stelle (etwa durch unterhalb der Folie oder durch in die Folie integrierte Aktoren) angezeigt werden, wo die entsprechende Funktion zu bedienen ist. Dieses kann beispielsweise durch eine der eigentlich Sensorfläche benachbarten Sensorfläche ausgelöst werden, die empfindlicher ausgelegt ist und schon bei Annäherung beispielsweise einer Hand reagiert und beispielsweise die Beleuchtung des eigentlichen Sensorfeldes auslöst.

Besonders vorteilhaft lässt sich mit diesen Eigenschaften des erfindungsgemäßen Flächenelements zur Verkleidung von Gegenstandsoberflächen in Bedienungsbereichen und/oder Aufenthaltsräumen von Fahrzeugen, in Luftfahrzeugen, Schiffen, Pkw und Lkw, dort insbesondere für Armaturenbretter, Sitz-, Wand- oder Türverkleidungen, Dachhimmel, oder Armauflagen verwenden.

Das erfindungsgemäße Flächenelement ist überall dort anwendbar wo Oberflächen, funktionelle Oberflächen und Dekoroberfläche mit einer Sensorik versehen werden sollen. So können auch beliebige Tisch- und Sitzmöbel, festinstalliert oder in Fahr- und Flugzeugen, Schiffen etc., Sitzbänke, medizinische Sitz- und Liegeflächen, Ski- und Sessselliftsitze so ausgerüstet werden.

Desweiteren können in Gebäuden beliebige Flächen (z. B., Bodenmatten, Fussböden, Wände, Decken etc.) mit der erfindungsgemäßen Folie ausgerüstet werden. Insbesondere in Fussböden kann beispielsweise eine Positionsdetektion erfolgen, so dass sich hier eine Anwendung in Alten- und Pflegeheimen anbietet. Die Erfindung ist nicht auf dekorative Kunstleder oder Folie beschränkt, sondern prinzipiell bei allen Flächengebilden anwendbar, die mit einer Sensorik ausgerüstet werden sollen.

Vorteilhaft kann die Erfindung insbesondere auch in medizinischen Anwendungen oder bei Sportgeräten sein, da beispielsweise bei medizinischen Möbeln, Bedienoberflächen, Operationsliegen etc. Öffnungen in der Oberfläche zum Anbringen von Schaltern und Reglern vermieden werden können und so eine wesentlich einfachere Desinfektion der Oberfläche möglich ist.

Diese Flächenelemente, auch die ggf. verwendeten Leder besitzen bevorzugt auch eine Lackierung beispielsweise zur Einstellung des optischen Oberflächeneindrucks, der Berührhaptik, der Abriebbeständigkeiten, der Medienbeständigkeiten gegen Reinigungsmittel und/oder Kratzbeständigkeiten. In einer bevorzugten Ausführungsform können die beschriebenen Flächenelement e/Dekorfolien auch dehnfähig sein.

Im Falle von Dekorfolien bestehen die Flächenelemente bevorzugt aus mindestens einer Lage Polymermaterial basierend auf Polyurethanen, PVC, Polyolefinen, Thermoplastischen Elastomeren, Thermoplastischen Polyurethanen oder Mischungen hieraus.

Möglich sind auch mehrlagige Dekorfolien, in denen eine oder mehrere Schichten geschäumt sein können.

Die Dekorfolien können, wie oben bereits beschrieben, textile Trägerrücken besitzen, die bevorzugt zur guten Bedruckbarkeit im Siebdruckverfahren eine möglichst ebene Oberfläche besitzen wie beispielsweise Gewebe (z.B. basierend auf Polyestern, Polyamiden, Baumwolle, Baumwolle/Polyester-Gemischen), Mikrofaservliese oder durch eine Lackierung verdichtete Vliese. Die eingesetzten Textilien können zur Darstellung einer besseren Bedruckbarkeit auch unter Wärmeeinfluss kalandriert werden.

Eine gute Bedruckbarkeit kann auch bei textilen Trägerrücken mit einer nicht glatten Oberfläche wie Gestricken, Gewirken oder nicht oder wenig verfestigten Vliesen erreicht werden, indem diese vorher bedruckt oder imprägniert werden oder mit einer Polymerfolie verklebt werden.

Anwendbar ist die erfindungsgemäße Lösung bei/mit verschiedensten flächigen Oberflächenmaterialien. Desweiteren können auch Nicht-Dekorfolien in der beschriebenen Art dargestellt werden, beispielsweise um Annäherungssensoren oder Positionssensoren in Füssböden etc. darzustellen.

Vorteilhafterweise werden, wie oben erwähnt, zur Bereitstellung der bedruckten elektrisch leitfähigen Materialien, insbesondere der elektrisch leitfähigen Kunstleder elektrisch leitfähige Pasten verwendet, die nach dem Trocknen eine gute Flexibilität und Dehnfähigkeit der flexiblen Flächengebilde ermöglichen. Es kann aber im Prinzip jede elektrisch leitfähige Paste verwendet werden und insbesondere solche elektrisch leitfähigen Pasten, die im Siebdruckverfahren verarbeitbar sind. Solche Pasten sind beispielsweise in der EP 2 457 944 A1 beschrieben.

Druckmuster und Sensorflächen lassen sich je nach Anwendung zur Optimierung und Einstellung der elektrischen Kapazität in einem weiten Rahmen variieren. Auch kann die Form der Sensorfläche für bestimmte Anwendungen unterschiedliche geometrische Formen besitzen oder beispielsweise auch gebogen sein. Insbesondere auch wenn Schieberegler durch eine kapazitive Sensorik dargestellt werden sollen, können Sensoren in einer linearen Reihe oder auch in einer gebogenen Form angeordnet sein (array). Diese nacheinander angeordneten Sensoren können beispielsweise auch ineinander verzahnt sein, ohne sich jedoch dabei zu berühren.

Zur besseren Abschirmung der Schichten aus leitfähigem polymerem Material in den funktionalen Flächenbereichen können auch benachbart Abschirmelektroden gedruckt werden. Desweiteren können zur Abschirmung und/oder zur Verbesserung der Empfindlichkeit der Sensoren auch zusätzliche elektrisch leitfähige Schichten eingebracht werden, die von der eigentlichen Sensorfläche aber durch eine isolierende Schicht getrennt sind. Realisieren lässt sich das dadurch, dass auf die Sensorfläche beispielsweise im Siebdruckverfahren eine isolierende Polymerschicht aufgebracht wird, woraufhin wiederum im Siebdruckverfahren die nächste elektrisch leitfähige Schicht aufgebracht wird, die dann beispielsweise geerdet werden kann.

Die Kontaktierung der Sensorflächen kann auf die oben beschriebene Art erfolgen oder auch dadurch, dass die Kontaktierungselektroden verbunden mit den Sensorflächen ebenfalls gedruckt werden und der Übergang zur Messelektronik an einem anderen Ort der gedruckten Kontaktierungselektrode stattfindet.

Die Empfindlichkeit der integrierten Sensorik kann z.B. durch Variation der eingesetzten elektrischen Widerstände so eingestellt werden, dass schon eine Annäherung an die Sensorfläche ohne direkte Berührung der Oberfläche detektiert werden kann. Auf diese Weise kann in einfacher Weise z.B. eine Steuerung von Funktionen durch das Ausführen von einfachen Gesten vor den Folienoberflächen realisiert werden.

Oben beschrieben wurde auch, dass zur besseren Bedienbarkeit der Sensorfunktionen optional eine Bedruckung der dekorativen Oberfläche stattfinden kann. Dieses kann in üblichen Druckverfahren wie Sieb-, Inkjet-Druck oder auch Flexodruck stattfinden.

Es wird also mit dem erfindungsgemäßen Flächenmaterial ein flexibles, dekoratives Kunstleder mit integrierten Sensorflächen u.a. für den Einsatz in Fahrzeugen bereitgestellt, welches sich optisch nicht unterscheidet von einer Dekorfolie ohne eine solche Sensorik. Die Möglichkeiten des Innenraumraumdesigns sind durch die Vermeidbarkeit von Stell-und Funktionsschaltern und Reglern deutlich verbessert, wobei die üblichen Verarbeitungsverfahren für automobile Dekorfolien wie Vernähen, Verpolstern, Tiefziehen oder Kaschieren anwendbar bleiben.

Das dekorative Flächenmaterial im Sinne der Erfindung kann also eine ein- oder mehrschichtige polymere Folie sein, wobei im Fall der mehrschichtigen Folie, eine oder mehrere Schichten ein oder mehrere textile Flächengebilde und/oder geschäumte flächige polymere Schichten wie Polyurethan- oder Polyolefin-basierte Schäume sein können. Ein dekoratives Flächenmaterial im Sinne der Erfindung kann auch ein textiles Flächengebilde mit einer textilen Oberfläche oder auch ein Leder sein. Diese Flächengebilde können auch mehrschichtig aufgebaut sein, wobei als weitere Schichten geschäumte Polymerschichten und/oder textile Schichten vorhanden sein können. Im Falle von Leder kann das Lederoch eine oder mehrere zusätzliche polymere Schichten auf der Oberfläche aufweisen. Diese Schichten können auch eine Oberflächenstruktur oder Narbung aufweisen.

Anhand von Ausführungsbeispielen soll die Erfindung näher erläutert werden. Zur Vorführung der erfindungsgemäßen Folie wurden zwei Demonstratoren aufgebaut. Als Elektronikkomponente wurde die Arduino-Plattform als Microcontroller und die zugehörige Software verwendet. Als Hardware können aber unterschiedliche I/O-Boards mit einem Microcontroller verwendet werden , die je nach Aufgabe auf Basis einer opensource-Software, die in einer library vorhanden ist, auf einer C/C++-basierten Programmiersprache programmiert werden können.

Die erhältlichen Boards können als elektronische Auswertungsschaltung für eine kapazitive Sensorik verwendet werden. Dabei werden verschiedene Pins des Boards als kapazitive Sensoren definiert, die die elektrische Kapazität des menschlichen Körpers messen können. Die so definierten pins müssen über einen mittleren bis hohen elektrischen Widerstand mit der Sensorfläche verbunden werden. Gemessen wird die Kapazitätsveränderung bei Annäherung eines menschlichen Körperteils.

Das erfolgt dadurch, dass der Microcontroller über den elektrischen Widerstand ein elektrisches Signal an den "send"-pin sendet, der mit einer Sensorfläche verbunden ist. Dabei wird die Zeit bzw. Verzögerung gemessen, bis das entsprechende Signal am "receive"-pin detektiert wird.

Auch wenn die Sensorfläche mit einem nichtleitenden Material bedeckt ist, funktioniert die elektronische Signalauswertung. Das von dem send-pin ausgehende Signal wird bestimmt durch eine RC-Zeitkonstante, die durch das Produkt aus elektrischem Widerstand R und Kapazität C, bestehend aus der Summe der Kapazität am receive-pin und der zusätzlichen Kapazität, die durch Wechselwirkung der Sensorfläche beispielsweise mit dem menschlichen Körper entsteht. Je nach der gewünschten Empfindlichkeit des Sensors sollte der elektrische Widerstand zwischen 1 Megaohm (Aktivierung bei Berührung der Oberfläche) und ca. 40 Megaohm (Aktivierung schon bei Annäherung an die Oberflächen; bis ca. 1 m Entfernung möglich) gewählt werden. Für ein fehlerfreies Funktionieren der Sensordemonstratoren ist eine ausreichende Erdung der Schalterelektronik unabdingbar und/oder zusätzlich ggf. noch durch ein nichtleitendes Material eine von der Sensorfläche beabstandete zweite elektrisch leitfähige Folie, die ebenfalls geerdet ist.

In dieser Beispielschaltung konnte mit Hilfe der erfindungsgemäßen flexiblen und dehnfähigen Dekorfolie mit von der Dekorseite aus unsichtbaren integrierten funktionalen Flächenbereiche ein Sensor- und Bedienelement bereitgestellt werden, mit dem ein Servomotor gezielt gesteuert wurde. Mit so einem prinzipiellen Aufbau ließe sich beispielsweise ein Fensterheber in der Türseite eines Kraftfahrzeugs bedienen.

Die Herstellung der dekorativen Folie, in der zwei von der Dekorseite unsichtbaren Sensorflächen integriert sind, erfolgt auf die oben beschriebene Weise. Auf die textile Rückseite der Folie werden mittels Siebdruckverfahren zwei quadratische Flächen von 2 cm Seitenlänge mit oben beschriebener elektrisch leitfähiger Paste gedruckt, wobei die Quadrate einen Mittelpunktabstand von 10 cm besitzen. Die Paste wird in so einer Stärke aufgetragen, dass die resultierende Schichtdicke der Druckschicht nach Trocknen ca. 30 $\mu$m beträgt. Die Kontaktierung erfolgt auf die oben beschriebene Art in der Weise, dass das Kontaktband mittig auf der gedruckten Sensorfläche platziert wird und nach Vorfixierung, Imprägnierung mit der leitfähigen Paste und Trocknen eine innige Kontaktfläche von ca. 1 cm² zu der Sensorfläche hat. Das Kunstleder wird auf einem Bauteilträger durch Kaschieren fixiert, so dass die dekorative Oberfläche sichtbar ist und die Kontaktbänder werden mit dem oben erwähnten Microcontroller verbunden, nämlich die Sensorfläche jeweils über einen elektrischen Widerstand von 1 Megaohm miteinander verbunden. Weiterhin werden die entsprechenden Anschlüsse mit einem Servomotor verbunden. Der Microcontroller wird dann entspechend mit der zugehörigen Software programmiert.

Nach Anschluss des Microcontrollers an einen PC-USB-Anschluss zur Stromversorgung kann der Servomotor durch leichtes Berühren des gefertigten Bauteils an den entsprechenden unsichtbaren Sensorflächen beliebig gesteuert werden. Die Dekorfläche ist dabei in ihrem Aussehen im Vergleich zu einer nicht mit Sensorflächen ausgerüsteten Dekorfolie in ihrem Aussehen identisch und flexibel, so dass auch stärkere Belastungen wie das kräftige Auflegen oder Anpressen eines Körperteils die Sensorfunktion nicht beeinflusst. Auch bei starkem manuellem Drücken auf die Folie bleibt die Funktion der Folie erhalten.

Eine weitere vorteilhafte und hier beispielhaft ausgeführte Ausbildung besteht darin, dass die funktionalen Flächenbereiche Mehrfachanordnungen (arrays) bilden und somit eine Positionserkennung erlauben.

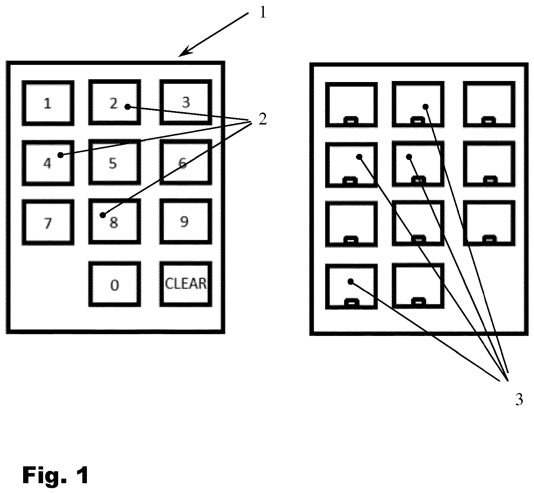

Hierzu zeigte ein weiteres Beispiel anhand der Fig. 1, wie durch die Anwendung der flexiblen und dehnfähigen Dekorfolie mit von der Dekorseite aus unsichtbaren integrierten Schichten 3 aus leitfähigem polymerem Material ein Aufbau/Bauteil hergestellt werden kann, mit dem ein "touch pad", d.h. ein mit Ziffern versehenes Bedienfeld 1 realisiert werden kann, mit dem beispielsweise spezifische Eingaben in Geräte über die Dekoroberfläche vorgenommen werden können.

In diesem Fall wurden die Position der zu berührenden Stellen des Kunstleders durch einen Aufdruck arabischer Ziffern auf den funktionalen Flächenbereichen 2 auf der Dekoroberfläche sichtbar gemacht, Auf die textile Rückseite wurden mittels Siebdruckverfahren quadratische Flächen mit je 2 cm Seitenlänge als Schichten 3 aus leitfähigem polymerem Material mit oben beschriebener elektrisch leitfähiger Paste bedruckt, wobei die rückseitigen Quadrate örtlich mit dem auf der Oberfläche befindlichen Aufdruck der Ziffern/ funktionalen Flächenbereiche 2 übereinstimmt.

Nach Ansschluss des Microcontrollers an einen PC- über die USB-Schnittstelle zur Stromversorgung kann das Bedienfeld 1 durch leichtes Berühren des gefertigten Bauteils an den entsprechenden funktionalen Flächenbereichen 2 beliebig bedient werden, so dass auf einem Display die korrespondierenden Zeichen erscheinen. Die Dekorfläche ist dabei in ihrem Aussehen im Vergleich zu einer nicht mit Sensorflächen ausgerüsteten Dekorfolie in ihrem Aussehen identisch und flexibel, so dass auch stärkere Belastungen wie das kräftige Auflegen oder Anpressen eines Körperteils die Sensorfunktion nicht negativ beeinflusst. Auch bei starkem manuellem Drücken auf die Folie bleibt die Funktion der Folie erhalten und die Sensorflächen waren nicht fühlbar.

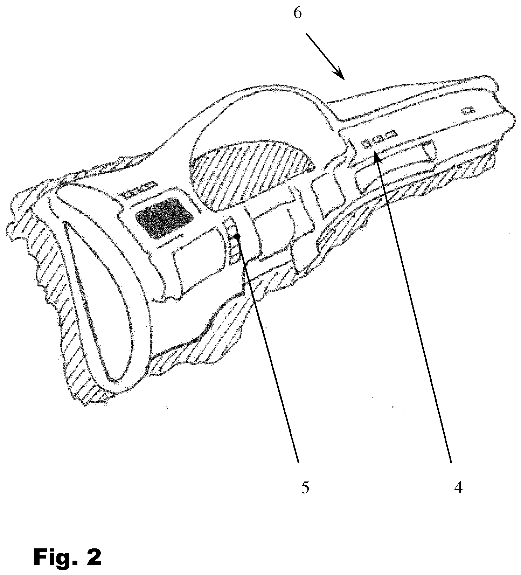

Fig. 2 zeigt noch einmal beispielhaft die Anordnung von in einer erfindungsgemäßen Folie integrierten anderen Ausführungen von funktionalen Flächenbereichen 4 und 5 für ein Armaturenbrett 6 eines Kfz.

**Bezugszeichenliste**

(Teil der Beschreibung)

1    Bedienfeld

2 funktionaler Flächenbereich
3 Schicht aus leitfähigem polymerem Material
4 funktionaler Flächenbereich
5 funktionaler Flächenbereich
6 Armaturenbrett

## Patentansprüche

1. Flexible Kunststofffolie aus polymerem Material als Verkleidung von Armaturenbrettern, Sitzen, Wänden oder Türen in Fahrzeugen , wobei die Kunststofffolie mit einer Narbung oder Prägung versehen ist, wobei die Kunststofffolie funktionale Flächenbereiche (2, 4, 5) aufweist, die in der Weise als Schalt-, Sensor- oder Bedienelement (1) ausgebildet sind, dass das Flächenmaterial mindestens im Bereich der funktionalen Flächenbereiche (2, 4, 5) mehrschichtig ausgebildet ist, wobei in den funktionale Flächenbereichen mindestens eine Schicht (3) aus leitfähigem polymerem Material angeordnet ist, die als Kondensatorplatte oder Kondensatorfolie ausgebildet ist, wobei die Schicht (3) aus leitfähigem Material von der sichtbaren Oberfläche des Flächenmaterials rückseitig beabstandet und mit einer elektronischen Steuer- und Regeleinrichtung verbunden ist, welche Veränderungen elektrischer Eigenschaften der Folie in den funktionalen Flächenbereichen detektiert und in Stell- Schalt- oder Steuersignale umformt, und wobei die Schichten (3) aus polymerem leitfähigem Material gleiche Dehnfähigkeit aufweisen wie die Folie aus polymerem Material und auf der Folienrückseite oder innerhalb der Dicke des Flächenmaterials angeordnet sind.

2. Kunststofffolie nach Anspruch 1, bei der in den funktionalen Flächenbereichen (2, 4, 5) unterhalb der sichtbaren Oberfläche mehrere als Kondensatorplatten oder Kondensatorfolien ausgebildete Schichten (3) aus leitfähigem Material angeordnet sind, insbesondere durch Folienmaterial voneinander isolierte Kondensatorplatten oder Kondensatorfolien.

3. Kunststofffolie nach Anspruch 1 oder 2 , bei der die als Kondensatorplatten oder Kondensatorfolien ausgebildeten Schichten aus leitfähigem Material als Teil eines Schwingkreises (LC-Kreis) ausgebildet sind.

4. Kunststofffolie nach einem der Ansprüche 1 bis 3, bei der die Schichten (3) aus leitfähigem Material als Antennen ausgebildet sind, die im Bereich der funktionalen Flächenbereiche ein elektrisches Feld erzeugen.

5. Kunststofffolie nach einem der Ansprüche 1 bis 4 ausgebildet als mehrschichtige Verbundfolie, bei der die Schichten (3) aus leitfähigem Material im Bereich der funktionalen Flächenbereiche aus elektrisch leitfähiger Polymermasse bestehen, welche als leitfähige Paste auf die Folienrückseite oder auf Folienschichten innerhalb des Folienverbundes aufgetragen wird, vorzugsweise im Siebdruckverfahren.

6. Kunststofffolie nach Anspruch 5, bei der die Beschichtung oder der Auftrag mit einer Menge zwischen 10 g/m$^2$ und 2000 g/m$^2$ erfolgt.

7. Kunststofffolie nach Anspruch 5 oder 6, bei der die leitfähige Polymermasse leitfähige feinteilige metallische und/oder metallisch beschichtete Füllstoffpartikel enthält, vorzugsweise in dendritischer Form oder in Kern-Schale-Morphologie.

8. Kunststofffolie nach einem der Ansprüche 1 bis 7, bei der die funktionalen Flächenbereiche (2, 4, 5) Mehrfachanordnungen bilden.

9. Kunststofffolie nach einem der Ansprüche 1 bis 8, bei der die funktionalen Flächenbereiche von der Folienrückseite oder von der Folienseite her beleuchtbar sind.

## Claims

1. Flexible sheet of plastic comprising polymeric material as trim for dashboards, seats, walls or doors in vehicles, the sheet of plastic being provided with a grain structure or embossing, the sheet of plastic having functional surface-area regions (2, 4, 5) which are designed in the form of a switching, sensor or operating element (1) in such a way that, at least in the region of the functional surface-area regions (2, 4, 5), the sheet-like material is of a multi-layered design, at least one layer (3) of conductive polymeric material that is designed as a capacitor plate or capacitor sheet being arranged in the functional surface-area regions, the layer (3) of conductive material being on the rear side at a distance from the visible surface of the sheet-like material and being connected to an electronic open-loop and closed-loop control device, which detects changes of electrical properties of the sheet in the functional surface-area regions and converts them into actuating, switching or control signals, and the layers (3) of polymeric conductive material having the same extensibility as the sheet of polymeric material and being arranged on the rear side of the sheet or within the thickness of the sheet of plastic.

2. Sheet of plastic according to Claim 1, in which a number of layers (3) of conductive material designed as capacitor plates or capacitor sheets, in particular capacitor plates or capacitor sheets insulated from one another by sheet material, are arranged in the functional surface-area regions (2, 4, 5) underneath the visible surface.

3. Sheet of plastic according to Claim 1 or 2, in which the layers of conductive material designed as capacitor plates or capacitor sheets are formed as part of an oscillating circuit (LC circuit).

4. Sheet of plastic according to one of Claims 1 to 3, in which the layers (3) of conductive material are designed as antennas, which generate an electric field in the region of the functional surface-area regions.

5. Sheet of plastic according to one of Claims 1 to 4, designed as a multi-layered composite sheet, in which the layers (3) of conductive material in the region of the functional surface-area regions consist of an electrically conductive polymer compound, which is applied as a conductive paste to the rear side of the sheet or to layers of the sheet within the composite sheet, preferably by the screen-printing process.

6. Sheet of plastic according to Claim 5, in which the coating or the application takes place with an amount of between 10 g/m$^2$ and 2000 g/m$^2$.

7. Sheet of plastic according to Claim 5 or 6, in which the conductive polymer compound contains conductive finely divided metallic and/or metallically coated filler particles, preferably of a dendritic form or core-shell morphology.

8. Sheet of plastic according to one of Claims 1 to 7, in which the functional surface-area regions (2, 4, 5) form multiple arrangements.

9. Sheet of plastic according to one of Claims 1 to 8, in which the functional surface-area regions can be illuminated from the rear side of the sheet or from the side of the sheet.

**Revendications**

1. Film de matière synthétique flexible en matériau polymère utilisé comme revêtement de tableaux de bord, de sièges, de parois ou de portes de véhicules, le film de matière synthétique étant pourvu d'un grain ou d'un gaufrage, le film de matière synthétique comportant des zones de surface fonctionnelles (2, 4, 5) qui sont conçues comme élément de commutation, de détection ou de commande (1) de telle sorte que le matériau de surface soit multicouche au moins au niveau des zones de surface fonctionnelles (2, 4, 5), au moins une couche (3) en matériau polymère conducteur, qui est conçue comme une plaque de condensateur ou un film de condensateur, étant disposée dans les zones de surface fonctionnelles, la couche (3) en matériau conducteur étant espacée de la surface visible du matériau de surface sur la face arrière et étant reliée à un dispositif de commande et de régulation électronique qui détecte des variations de propriétés électriques du film dans les zones de surface fonctionnelles et qui les convertit en signaux de réglage, de commutation ou de commande, et les couches (3) en matériau conducteur polymère ayant la même extensibilité que le film en matériau polymère et étant disposées sur la face arrière du film ou dans l'épaisseur du matériau de surface.

2. Film de matière synthétique selon la revendication 1, plusieurs couches (3) en matériau conducteur, conçues comme des plaques de condensateur ou des films de condensateur, en particulier des plaques de condensateur ou des films de condensateur isolés les uns des autres par un matériau pelliculaire, étant disposées dans les zones de surface fonctionnelles (2, 4, 5) sous la surface visible.

3. Film de matière synthétique selon la revendication 1 ou 2, les couches en matériau conducteur, conçues comme des plaques de condensateur ou des films de condensateur, faisant partie d'un circuit oscillant (circuit LC).

4. Film de matière synthétique selon l'une des revendications 1 à 3, les couches (3) en matériau conducteur étant conçues comme des antennes générant un champ électrique au niveau des zones de surface fonctionnelles.

5. Film de matière synthétique selon l'une des revendications 1 à 4 conçu comme un film composite multicouche, les couches (3) en matériau conducteur comprenant au niveau des zones de surface fonctionnelles une masse polymère électriquement conductrice qui est appliquée comme une pâte conductrice sur la face arrière du film ou sur des couches de film à l'intérieur du film composite, de préférence par sérigraphie.

6. Film de matière synthétique selon la revendication 5, le revêtement ou l'application étant effectué dans une quantité comprise entre 10 g/m$^2$ et 2000 g/m$^2$.

7. Film de matière synthétique selon la revendication 5 ou 6, la masse polymère conductrice contenant des particules de charge conductrices finement divisées métalliques et/ou pourvues d'un revêtement métallique, de préférence sous forme dendritique ou avec une morphologie cœur-coque.

8. Film de matière synthétique selon l'une des revendications 1 à 7, les zones de surface fonctionnelles (2, 4, 5) formant des agencements multiples.

9. Film de matière synthétique selon l'une des revendications 1 à 8, les zones de surface fonctionnelles pouvant être éclairées depuis la face arrière du film ou depuis le côté du film.

**Fig. 1**

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006097991 A1
- US 7145432 B2
- DE 102006008385 A1
- US 4562315 A
- EP 2457944 A1